# EUROPÄISCHE PATENTSCHRIFT

(11) **EP 2 272 080 B1**
(45) Veröffentlichungstag und Bekanntmachung des Hinweises auf die Patenterteilung: **01.08.2012**
(21) Anmeldenummer: 09737866.5
(22) Anmeldetag: 28.04.2009
(51) Int. Cl.: H01J 37/34, C23C 14/14, C23C 14/35, C23C 14/34, C23C 14/02

(54) **VORRICHTUNG UND VERFAHREN ZUM VORBEHANDELN UND BESCHICHTEN VON KÖRPERN**
DEVICE AND METHOD FOR PRETREATING AND COATING BODIES
DISPOSITIF ET PROCEDE DE PRETRAITEMENT ET DE REVETEMENT DE CORPS

(30) Priorität: 28.04.2008 DE 102008021128
(43) Veröffentlichungstag der Anmeldung: 12.01.2011
(73) Patentinhaber: CemeCon AG, 52146 Würselen (DE)
(72) Erfinder: CREMER, Rainer, 52156 Monschau (DE); MAY, Walter, B-4728 Kelmis (BE)
(74) Vertreter: Kalkoff & Partner
(86) Internationale Anmeldenummer: PCT/EP2009/003082
(87) Internationale Veröffentlichungsnummer: WO 2009/132822

(56) Entgegenhaltungen:
- WO-A-2006/049566
- DE-A1-102006 017 382
- DE-A1-102006 021 994
- US-A1- 2007 188 104
- CHRISTIE D J ET AL: "Power supply with arc handling for high peak power magnetron sputtering" JOURNAL OF VACUUM SCIENCE AND TECHNOLOGY: PART A, AVS /AIP, MELVILLE, NY., US, Bd. 22, Nr. 4, 1. Juli 2004 (2004-07-01), Seiten 1415-1419, XP012073747 ISSN: 0734-2101

## Beschreibung

Die Erfindung betrifft eine Vorrichtung sowie ein Verfahren zum Vorbehandeln und Beschichten von Körpern mittels Magnetronzerstäubens.

Es ist bekannt, Körper oder Teile von Körpern mit einer Oberflächenbeschichtung zur Verbesserung der mechanischen Eigenschaften zu versehen. Besonders haben sich hier plasmagestützte PVD-Verfahren, wie das arc-Verdampfen und das Magnetronsputtern bewährt, wobei das Beschichtungsmaterial von so genannten Targets mittels Plasmaeinwirkung abgetragen wird und sich anschließend auf den Substraten niederschlägt.

Ein Magnetron beinhaltet neben einem Target Kühleinrichtungen, ggf. elektrische Abschirmungen und insbesondere Mittel zum Erzeugen von Magnetfeldern, die die Plasmadichte vor dem Target erhöhen. Im Betrieb des Magnetrons wird das Target als Kathode geschaltet gegenüber der Kammerwandung und/oder gegenüber der Abschirmung des Magnetrons, oder gegenüber einer separaten Elektrode, die als Anode fungiert.

Gegenüber dem Arc-Verdampfen weist das Magnetronsputtern Vorteile auf, da die flüssige Phase vermieden wird. Somit wird eine fast unbegrenzte Spanne an Schichtlegierungen möglich und die Schichten sind frei von Wachstumsfehlern, sog. Droplets.

Allerdings beträgt der Ionisierungsgrad der Beschichtungsteilchen beim herkömmlichen Magnetronsputtern maximal einige wenige Prozent. Die Ionisation ist vor dem Target am höchsten und dehnt sich kaum in den Beschichtungsraum aus. Dies kann durch asymmetrische magnetische Felder hinter dem Magnetron, so genanntes unbalanziertes Magnetron (UBM) etwas verbessert werden, ist jedoch gerade bei großen Beschichtungsvolumina, wie sie in kommerziellen Anlagen üblich sind, nicht ausreichend. Ferner besteht die Ionisation weit überwiegend aus Ionen des Arbeitsgases und nur zu einem sehr kleinen Teil aus ionisiertem Material des Targets.

Metallionen haben u. a. den Vorteil, dass sie so gewählt werden können, dass sie zum Bestandteil des Beschichtungsmaterials gehören und die Schicht nicht kontaminieren. Ferner haben sie geringere Ionisierungsenergie als die üblichen Prozessgase.

Eine Variante dieses Verfahren, die diesen Nachteil vermeidet, ist das so genannte "hochleistungsgepulste Magnetronzerstäuben" (englisch "High Power Puls Magnetron Sputtering" oder kurz HPPMS). Hier wird durch kurze, aber sehr energiereiche Impulse der elektrischen Plasmageneratoren eine hohe Ionisationsdichte der Beschichtungsteilchen vor dem Magnetron erzielt, die bis an 100% heranreichen. Bei einem hinreichend energiereichen Puls steigt der Strom so schnell an, dass die Plasmazustände der Glimmentladung und der Hochstrom-Bogenentladung (Arc) so schnell durchlaufen werden, dass sich vor dem Magnetron ein stabiles Plasma mit sehr hoher Ladungsträgerdichte ausbilden kann. Die maximal zugeführte Leistung während eines Pulses kann dabei bis in den Megawatt-Bereich hineinreichen und die dem Target zugeführte Leistung pro cm² Targetfläche in den Kilowatt-Bereich, so dass die Pulszeit entsprechend kurz gewählt werden muss, um Beschädigungen des Magnetrons zu vermeiden.

HPPMS bietet zahlreiche Vorteile. Durch elektrische und magnetische Felder können sowohl die Energie, als auch die Richtung oder Flugbahn der ionisierten Beschichtungsteilchen, i. d. R. Ionen, bestimmt werden. Durch das beim Magnetronsputtern in der Regel an das Substrat angelegte negative Potential (Bias) werden nun auch Hohlräume oder nicht in Sichtlinie liegende Flächen des Substrates gut erreicht. Der Bias bestimmt ferner auch die Energie der Ionen, von denen zahlreiche Schichteigenschaften abhängen. Auf der Seite des Magnetrons wird durch den hohen Ionenbeschuss eine wesentlich bessere Ausnutzung des Beschichtungsmaterials bzw. des Targets erreicht. Darüber hinaus wird die so genannte Targetvergiftung durch Reaktion mit Reaktivgasen verhindert. Beim konventionellen Magnetronsputtern von Metalltargets im Reaktivgas bilden sich isolierende Reaktivschichten auf den Magnetron, die ein effektives Zerstäuben des Metalls verhindern und zu isolierenden Schichten und Aufladungen und Arcs führen können. Wird dies durch Absenken des Reaktivgasdrucks verhindert, haben die Schichten dagegen einen zu hohen Metallanteil und reduzierte Härte. Gerade Hartstoffschichten setzen sich aber in der Regel aus Verbindungen mit festem stöchiometrischen Verhältnis von Metallen und Nichtmetallen zusammen. Man muss jeweils einen Kompromiss aus Schichtrate und Reaktivgasfluss wählen, der während der des Prozesses genauestens eingehalten werden muss. Beim HPPMS mit einem hohem Anteil an Ionen des Targets, insbesondere an Metallionen, wird ein Teil der Metallionen jedoch auf das Target zurückbeschleunigt und die Targetvergiftung unterbunden. Der genaue Arbeitspunkt ist also weniger kritisch und es kann bei reaktiven Prozessen mit einer dem konventionellen Sputtern ähnlichen Schichtrate beschichtet werden.

Bei rein metallischen Schichten, bei denen sich kein Problem der Targetvergiftung ergibt, kann die Schichtrate beim HPPMS allerdings hinter der des konventionellen Magnetronsputterns zurückbleiben.

Die hohe Ionisation betrifft nicht nur die vorhandenen Sputter- und Reaktivgase, sondern auch die vom dem HPPMS-Target freigeschlagenen Ionen des Targets, bevorzugt des Metalltargets. Der HPPMS Prozess kann auch bei sehr niedrigen Drücken betrieben werden, so dass die HPPMS-Elektrode fast ausschließlich als Quelle von Metallionen dienen kann. Die Metallionen können zum Beschichten, aber auch zur Vorbehandlung der Substrate, auch bezeichnet als Ätzen, genutzt werden. Die Vorbehandlung erfolgt insbesondere durch Wegsputtern von Verunreinigungen oder durch die Implantation von Metallionen ins Substrat. Hierzu wird eine höhere Biasspannung ans Substrat gelegt.

Die Grundlagen des HPPMS finden sich bei Kouznetsov, besonders in der PCT-Anmeldung WO 98/040532. Die Ausführung spezieller Leistungsversorgungen findet sich in der US6296742. Die EP1609882 stellt verschiedene Möglichkeiten dar, die Ionen nach dem Puls auf die Substrate zu lenken. D. J. Christie erläutert in "Target material pathways model for high power pulsed magnetron sputtering" in J.Vac.Sci.Tech. A, 23(2) (2005) 330, die Effekte, die zum Ratenverlust beim HPPMS führen.

Es ist Aufgabe der Erfindung, ein Verfahren und eine Vorrichtung zu beschreiben, mit denen eine effektive Vorbehandlung und Beschichtung von Substraten möglich ist.

Diese Aufgabe wird gelöst durch eine Vorrichtung nach Anspruch 1 und ein Verfahren nach Anspruch 15. Abhängige Ansprüche beziehen sich auf vorteilhafte Ausgestaltungen der Erfindung. Hierbei sind die vorgeschlagenen Verbesserungen bekannter Verfahren in die einzelnen o.g. Aspekte gegliedert, können aber auch zwischen den Aspekten in beliebiger Form kombiniert werden.

Eine vorrichtung entsprechend der Präambel von Anspruch 1 ist aus DE 10 2006 021 994 bekannt. Mit den erfindungsgemäßen Vorrichtungen und dem erfindungsgemäßen Verfahren können im Prinzip beliebige Körper vorbehandelt werden und beliebige Schichten aufgebracht werden. Bevorzugt sind beständige und/oder harte Schutzschichten auf Bauteilen und Werkzeugen, im Besonderen auf Werkzeuge zum Zerspanen. Wie nachfolgend, insbesondere im Zusammenhang mit den bevorzugten Ausführungsbeispielen, näher erläutert wird, ist es insbesondere bevorzugt, Hartstoffschichten mit oder ohne Zwischen-, Übergangs- und Haftschichten auf den Substraten aufzubringen. Unter Hartstoffschichten werden hier Schichten wie bspw. Ti-Al-N, Al₂O₃ oder vergleichbarer Härte verstanden.

Die erfindungsgemäß vorgeschlagene Vorrichtung nach Anspruch 1 ist zum Vorbehandeln und Beschichten von Körpern durch Magnetronzerstäuben vorgesehen. Sie umfasset eine Vakuumkammer mit metallischer Kammerwandung. In der Vakuumkammer sind Magnetrons mit Sputter-Targets angeordnet, bevorzugt Metall-Targets.

Mindestens eines der Magnetrons ist als HPPMS-Magnetron ausgebildet, d.h. es kann nach dem hochleistungsgepulsten Magnetronzerstäuben betrieben werden. Hierfür ist es mit einer HPPMS-Leistungsversorgung verbunden.

Optional können zusätzlich auch konventionelle Magnetrons in der Vakuumkammer vorgesehen sein. Unter konventionellen Magnetrons sind solche Typen zu verstehen, die keine HPPMS-Magnetrons sind. Im Stand der Technik sind hier verschiedene Typen bekannt. Es kann sich also bspw. um DC-betriebene, Hochfrequenz-betriebene, im Mittelfrequenzbereich betriebene, unipolar oder bipolar gepulste Magnetrons handeln. Im Fall bipolar gepulster Magnetrons liegt die Pulsfrequenz bevorzugt bei 1-500 kHz, weiter bevorzugt bei 2-200 kHz, besonders bevorzugt bei 4-100 kHz.

Von einem HPPMS Magnetron wird hier gesprochen, wenn das Magnetron im HPPMS Modus betrieben werden kann, d.h. an eine geeignete HPPMS-Leistungsversorgung angeschlossen ist. Hier wird unter HPPMS verstanden, dass der bei Kouznetsov in WO 98/040532 beschriebene Ionisierungszustand erreicht wird, was an der Spannung und der Stromdichte erkennbar ist.

Ferner ist für den HPPMS-Betrieb ein geringes Verhältnis zwischen der Pulsdauer und der Pulspause von unter 0,1 charakteristisch, d.h. dass die Pulspause mehr als zehn mal so lang ist wie die Pulsdauer. Typische Pulszeiten betragen bspw. 100µs.

Als zusätzliches, optionales Kriterium für den HPPMS-Betrieb kann gelten, das die Leistungsdichte relativ gleichmäßig über das Target verteilt ist.

In der Literatur wird bei HPPMS oft von Leistungsdichten im Puls von über 1000 W/cm² (berechnet als elektrische Leistung eines Targets geteilt durch die Targetfläche) auf dem Target gesprochen. Es hat sich bei den Versuchen jedoch gezeigt, dass solche Leistungsdichten oft nicht erreichbar sind, insbesondere wenn isolierende Schichten wie Aluminiumoxid aufgebracht werden, die speziellen Vorteile des HPPMS-Betriebs jedoch schon bei geringeren Leistungsdichten auftreten. So haben sich die Vorteile bereits bei Leistungsdichten ab lediglich 600 W/cm², aber auch schon ab lediglich 300 W/cm² gezeigt.

Alle Magnetrons werden bevorzugt mit drei Magnetpolen hinter dem Target betrieben. Der mittlere Pol hat bevorzugt ein stärkeres Feld als die Außenpole. Solche Magnetrons werden auch als unbalanzierte Magnetrons (UBM) bezeichnet.

Bei dem erfindungsgemäß vorgesehenen HPPMS-Magnetron kann es sich von der Ausführung des Magnetrons selbst um ein einen herkömmlichen Typ handeln. Es ist aber nicht ausgeschlossen, dass die mit HPPMS betriebenen Magnetrons durch konstruktive Maßnahmen besonders an diese Betriebsart angepasst sind.

Bei der Vorrichtung gemäß Anspruch 1 werden dem HPPMS-Magnetron elektrische Pulse zugeführt, indem ein Kapazitätselement durch ein Schaltelement mit dem Sputter-Target des HPPMS-Magnetrons elektrisch verbunden wird. Erfindungsgemäß ist hierbei das Schaltelement an der Kammerwandung angeordnet.

Gemäß der in Anspruch 1 beanspruchten Erfindung wird angestrebt, die Schaltelemente für den HPPMS-Puls möglichst nahe bei den zugehörigen HPPMS-Elektroden anzubringen. Während die Ströme zum Aufladen der HPPMS-Kondensatoren moderat sind, treten beim Entladen des Kapazitätselements extrem hohe und kurze Leistungsimpulse mit entsprechenden intensiven und breitbandigen Störungen auf. Erfindungsgemäß wird das Schaltelemente direkt an der Außenseite der Kammerwand, bevorzugt nahe an der für den Anschluss an das Magnetron verwendeten Vakuumdurchführung, befestigt.

Durch die extrem hohen Pulsenergien beim HPPMS treten hohe elektrische und elektromagnetische Störungen auf, die die komplexen Regelkreise in modernen Industrieanlagen empfindlich stören können. Die Probleme verschärfen sich bei Mehrkathodensystemen und großen Abständen zwischen den Elektroden wie in den nachfolgend beschriebenen Betriebsarten. Beim Aufbringen von isolierenden Schichten verschärfen sich die Probleme weiter, da in diesen Fällen oft mehr Elektroden im Pulsbetrieb betrieben werden. Aufladungen und das Entstehen von Bogenentladungen verursachen einerseits verstärkt elektromagnetische Störungen, anderseits wird ein erhöhter Aufwand an Regelkreisen notwendig. Hier sind im Besonderen elektronische Schaltungen zum raschen Erkennen und Abschalten von Arc zu nennen.

Durch die erfindungsgemäße Anordnung des Schaltelements gemäß Anspruch 1 werden Leitungslängen des geschalteten Strom, insbesondere Leitungslängen außerhalb der Kammer, erheblich verringert. Es hat sich erwiesen, dass mit der erfindungsgemäßen Anordnung erheblich geringere elektromagnetische Störungen auftreten.

Die wesentlichen Elemente der gemäß Anspruch 1 vorgesehenen HPPMS-Versorgung sind das Kapazitätselement, das in den Pulspausen bevorzugt kontinuierlich nachgeladen wird, und ein Schaltelement, das zur Erzeugung eines Pulses das geladene Kapazitätselement entleert. Die Dauer und Abfolge der Pulszeiten kann über eine Steuervorrichtung bestimmt werden. Das Schaltelement kann zwar im Prinzip ein mechanischer Schalter sein, ist aber bevorzugt aus IGBT (Insulated Gate Bipolar Transistor) Leistungshalbleitern aufgebaut.

Das Kapazitätselement muss hohe Spannungen und Ströme liefern. Gemäß einer Weiterbildung der Erfindung werden einzelne Kondensatoren hoher Spannungsfestigkeit (bevorzugt mehr als 1000V, besonders bevorzugt 2000V Spannungsfestigkeit oder mehr) in enger Packungsdichte elektrisch parallel zu einer Kondensatorbank zusammengeschaltet. Bevorzugt umfasst die Kondensatorbank mehr als 5, besonders bevorzugt mehr als 10 Kondensatoren in Parallelschaltung. Die Gesamtkapazität der Kondensatorbank beträgt bevorzugt 20 - 100µF, weiter bevorzugt mehr als 30µF, besonders bevorzugt mehr als 40µF.

Ein Schaltelement und/oder eine Kondensatorbank kann auch zusammen mit der Vakuumdurchführung eine Einheit bilden. Diese Einheit kann beispielsweise in einem gemeinsamen Gehäuse angeordnet sein.

Ferner können Kühleinrichtungen, die an den Durchführungen oder der Kammerwand bereits vorgesehen sind auch für die Schaltelemente genutzt werden. Gleiche Maßnahmen sind auch für die Schaltelemente für den Dual-Magnetron-Betrieb vorteilhaft.

In einer bevorzugten Ausführungsform mit einem Elektrodenpaar, dessen Elektroden in einem vergleichsweise hohen Abstand angeordnet sind, ist durch die entsprechend langen Zuleitungen das Risiko elektromagnetischer Störungen erhöht. In einer bevorzugten Ausführungsform werden die Leitungen daher innerhalb der metallischen Beschichtungskammer geführt und dadurch elektromagnetische Störungen im Außenraum vermindert. In einer weiter bevorzugten Ausführungsform werden die Zuleitungen der Gegenelektrode oder Anode mit der gleichen Vakuumdurchführung in die Kammer geführt wie auch die Zuführungen zur Elektrode selbst.

Die Weiderbildung der Erfindung gemäß abhängigem Anspruch 7 geht von der Grundüberlegung aus, dass mit bekannten Vorrichtungen und Verfahren zwar hohe Ionendichten vor den Magnetrons erzielt werden, diese Ionendichten aber im Beschichtungsvolumen, d.h. am Ort der zu beschichtenden Substrate, nicht durchgehend nutzbar sind. Dies gilt vor allem für HPPMS sowie für kommerzielle Anlagen mit großen Beschichtungsvolumina und größeren Abständen zwischen Substraten und Magnetrons. Die Erfindung ermöglicht ein Vorbehandeln und Beschichten von Substraten mittels Magnetronsputterns, bei dem sowohl eine hohe Metallionendichte als auch eine hohe Gasionendichte im gesamten Beschichtungsvolumen erreicht werden kann. Dadurch, dass bevorzugt in der Vakuumkammer sowohl einerseits herkömmliche, bspw. DC-Magnetrons als auch andererseits HPPMS-Magnetrons vorgesehen sind, kann durch entsprechende Wahl der elektrischen Leistung der jeweiligen Magnetrons die Menge an Metallionen einerseits und an Gasionen andererseits vorgegeben werden.

Die hohe Ionendichte wird erreicht durch eine besondere Verschaltung von Elektroden. In der Vakuumkammer ist mindestens ein plasma-erzeugendes Elektrodenpaar angeordnet. Das Elektrodenpaar umfasst als erste Elektrode ein HPPMS-Magnetron. Die zweite Elektrode kann, wie nachfolgend näher erläutert wird, ein zweites HPPMS-Magnetron, ein herkömmliches Magnetron oder eine Anode sein.

Daher sind die erste und die zweite Elektrode bevorzugt so angeordnet, dass ein am Substrattisch aufgenommener Körper zwischen den aktiven Flächen des Elektrodenpaares angeordnet ist oder durch den Zwischenraum der aktiven Flächen des Elektrodenpaares bewegt wird.

Somit sind bevorzugt die Gegenpole eines oder mehrerer Magnetrons so angeordnet, dass die Sichtverbindungslinien der wirksamen Elektrodenflächen zumindest teilweise und zeitweise die zu behandelnden Substrate kreuzen. Dies heißt in der Regel auch, dass die elektrischen Feldlinien zwischen zwei zugeordneten Elektroden eines Elektrodenpaares zumindest teilweise und zeitweise die Substrate kreuzen und die Substratoberflächen mit Ladungsträgern insbesondere mit Metallionen und Gasionen behandelt werden. Die geschieht im einfachsten Falle dadurch, dass die Substrate zwischen das Elektrodenpaar gebracht werden bzw. durch den Zwischenraum des Elektrodenpaares hindurchbewegt werden.

Hierbei können die Magnetrons als normale Magnetrone oder als HPPMS-Magnetone betrieben werden.

Unter einem Elektrodenpaar in dieser Schrift werden zwei Elektroden und eine elektrische Leistungsversorgung verstanden, wobei die Elektroden über die elektrische Leistungsversorgung miteinander verbunden sind. Die Verbindung muss nicht zwingend direkt sein. Sie kann über Entstör- oder Anpassnetzwerke, Schaltelemente und oder andere elektrische Elemente geführt werden. Ausschlaggebend ist, dass die elektrische Energie, die an die Elektroden abgeführt wird, überwiegend von der zugehörigen Leistungsversorgung geliefert wird. Eine Elektrode kann auch Teil mehrerer Elektrodenpaare sein. Von einem Magnetronelektrodenpaar wird gesprochen wenn mindestens eine Elektrode eine Magnetronelektrode ist.

Eine Elektrode eines Elektrodenpaares wird als Anode bezeichnet, wenn sie sich überwiegend auf positivem Potential gegenüber der zweiten Elektrode befindet. Hingegen wird eine Elektrode eines Elektrodenpaares als Kathode bezeichnet, wenn sie sich überwiegend auf negativem Potential gegenüber der zweiten Elektrode befindet.

Ein Elektrodenpaar, bei dem zwei Magnetrons als Elektroden verwendet werden, die wechselseitig gegeneinander (bipolar) gepolt werden, so dass die Elektroden abwechselnd Anode und Kathode sind, wird auch als Dual-Magnetron bezeichnet, die entsprechende Betriebsart als Dual-Magnetron-Betrieb.

Die Kammer weist bevorzugt die üblichen Vorrichtungen einer Sputteranlage auf, wie geregelte Gaseinlässe für Arbeits- und Reaktivgase und einen abgepumpten Gasauslass. Ein Substrattisch befindet sich bevorzugt in der Mitte der Anlage. Die Elektroden, insbesondere die Magnetrons, befinden sich bevorzugt in der Nähe der Wände und sind um den Substrattisch herum angeordnet, bevorzugt in gleichmäßiger Anordnung. Dabei sind die Targets in Richtung auf die Substrate ausgerichtet. Der Tisch ist bevorzugt drehbar, so dass sich das Substrat oder die Substrate an den Magnetrons vorbei bewegen können. Es können auf dem Drehtisch auch weitere Drehachsen vorhanden sein, so dass mehrere Substrate von allen Seiten in einer planetären Drehung beschichtet werden können. Der Raum, in dem die Substrate vorbehandelt und beschichtet werden, wird auch als Beschichtungsvolumen bezeichnet, die Gesamtheit aller Substrate zusammen mit den zugehörigen Halterungen als Charge. Bei mindestens einem Magnetronelektrodenpaar kreuzt mindestens eine Sichtlinie zwischen den aktiven Elektrodenflächen zumindest teilweise und zeitweise das oder die Substrate. Durch diesen vergleichsweise großen Abstand wird eine hohe Ionisation in der gesamten Kammer erzeugt, da sich Elektronen von der Kathode zur Anode bewegen und dabei auf dem gesamten Weg zusätzliche Ionisation bewirken. Ist die Kammer mit einem Arbeits- und/oder Reaktivgas gefüllt, wird auf diese Weise eine hohe Gasionisation erzeugt.

Das erfindungsgemäß vorhandene HPPMS Magnetron sorgt vor allem für eine hohe Metallionendichte. Es hat sich herausgestellt, dass die Ionisation erhöht und im Beschichtungsvolumen weiter ausgeweitet wird, wenn eine Anode vorgesehen ist, die gegenüber der Kammerwand auf einem bestimmten positiven Potential gehalten wird. Dazu wird bevorzugt zwischen Anode und Kammerwand eine bevorzugt spannungsgeregelte elektrische Leistungsversorgung angeschlossen.

Gemäß einer Wederbildung der Erfindung kann eine besondere Art des Übergangs zwischen Ätzen und Beschichten vorgesehen sein.

Beim Beschichten sowie bei der Vorbehandlung von Substraten werden die Substrate üblicherweise mit einem negativen Potential beaufschlagt. Dieses Potential wird häufig auch als Bias-Potential bezeichnet und zieht Ionen auf die Substratoberfläche. Dies führt beim Beschichten u. a. zu einer Verdichtung der Schichten und zum Abbau von Zugspannungen, und steigert so die Schichtqualität und Schichthaftung. Unter Ätzen wird das Entfernen von Verunreinigungen, aber auch von Bestandteilen des Substrates verstanden. Im Gegensatz zum Beschichten kommt es hier zu einer Entfernung von Material. Beim Ionenätzen ist das Bias-Potential in der Regel stärker negativ eingestellt. Durch diesen starken Beschuss werden die Substratoberflächen gereinigt und aktiviert. Im Falle von Beschuss mit Metallionen im HPPMS-Betrieb und hohen Biasspannungen können die Metallionen auch oberflächennah implantiert werden. Dies verbessert das anschließende Aufwachsen der Schichten. Durch Variation der Biasspannung kann ein kontinuierlicher Übergang zwischen Ätzen und Beschichten und damit zwischen Substrat und Schicht erzeugt werden.

Durch die freie Wahl der Metalltargets, bevorzugt der HPPMS-Metalltargets, kann der Übergang zwischen Substrat und Schicht vielseitig gestaltet werden. Da das Ätzen und Beschichten mit den gleichen Metallen durchgeführt werden kann, lässt sich eine gradiertes Interface und eine sehr gute Haftung herstellen, indem zunächst in einem Ätz-Schritt eine hohe negative Bias-Spannung von bspw. 1000 V am Substrat angelegt wird und diese Bias-Spannung dann kontinuierlich abgesenkt wird.

In einer bevorzugten Ausführungsform des erfindungsgemäßen Verfahrens werden zunächst Metallatome in die Substrate implantiert, indem bei laufenden HPPMS-Targets Metallionen bei hohem negativem Substratbias von bspw. -1200 V auf das Substrat beschleunigt werden. Dann wird eine dünne metallische Zwischenschicht aus dem gleichen Material erzeugt, indem die Biasspannung reduziert wird. Anschließend kann durch Zugabe eines Reaktivgases eine ebenfalls dünne Hartstoffzwischenschicht unter Einbeziehung des gleichen Metalls aufgebracht werden. Schließlich wird die eigentliche Hartstoffschicht aufgebracht. Dabei können drei Fälle unterschieden werden: Erstens, die Metalle der Zwischenschichten unterscheiden sich von den Metallen der Hartstoffschichten; zweitens, mindestens ein Metall der Zwischenschichten findet sich auch in den Hartstoffschichten und drittens die Metalle in den Zwischenschichten und Hartstoffschichten sind im Wesentlichen identisch. Bei den vielfältigen Einsatzfällen von Hartstoffschichten kann die günstigste Konstellation durch Versuche jeweils ermittelt werden. Die Metalle Ti und Cr haben sich jedoch als Element für die Zwischenschichten besonders bewährt.

Bevorzugt können die Zwischenschicht und die Hartstoffzwischenschicht jeweils eine Dicke von 1-200 nm, besonders bevorzugt von 10-100 nm aufweisen.

Durch eine geeignete Einstellung von Gasionen- und Metallionendichte können zusätzlich optimale Übergänge im Interfacebereich erzeugt werden. Dabei ist es besonders günstig, dass während des HPPMS-Ätzens gleichzeitig auch ein ausreichender Beschuss mit Gasionen stattfindet. Es hat sich ferner gezeigt, dass ein dem HPPMS vorgeschaltetes reines Gasätzen die Haftung weiter verbessert.

Die Biasspannung kann zwischen Substrattisch und Kammer angelegt werden. Bevorzugt ist jedoch das Anlegen einer Bias-Versorgung zwischen Substrattisch und Anode. Bevorzugt hat eine Kammer nur ein Anodenpotential, welches das positivste Potential aller für die Substratbehandlung und -beschichtung benötigten Elektroden darstellt. Es können jedoch mehrere räumlich getrennte Anoden miteinander verbunden und so auf dieses Potential gelegt werden.

Die bevorzugte Einstellmöglichkeit von Gasionen- und Metallionendichte ermöglicht weiter die Optimierung von zahlreichen Eigenschaften wie Schichtqualität, Schichtrate Schichtzusammensetzung, Schichtstruktur und Schichtspannungen. Auch zahlreiche Variationen bei Multilayern sind möglich.

In einer bevorzugten Variante werden die HPPMS-Magnetrone gegen eine weit entfernte Anode geschaltet. Überstreicht ein Substrat die Sichtlinie zwischen HPPMS-Target und der zugehörigen Gegenelektrode wird in Substratnähe eine hohe Metallionendichte und Gasionendichte erreicht. Die Elektronen erzeugen auf ihrem Weg zur Gegenelektrode Gasionisation; ferner werden auch gesputterte oder rekombinierte Metallatome neu ionisiert bzw. einfachionisierte Metallionen mehrfach ionisiert.

Überraschenderweise hat sich diese Methode beim Beschichten von isolierenden Schichten, bevorzugt oxidischen, besonders bevorzugt Aluminiumoxidschichten besonders bewährt. Die Prozesse laufen stabiler, da es weniger Aufladungen und Arcs auftreten. Das gleiche gilt aber auch, wenn ein konventionelles Magnetronpaar im Dual-Magnetron-Mode betrieben wird, gleichzeitig aber auch HPPMS-Magnetrone betrieben werden. Die Schichtrate ist in diesen Fällen sogar höher als wenn nur mit konventionellen Magnetronen gearbeitet wird.

Im Folgenden werden Ausführungsformen der Erfindung anhand von Zeichnungen näher beschrieben. Dabei zeigen
- Fig. 1: in einer Prinzipskizze einen waagerechten Querschnitt durch eine erste Ausführungsform einer Beschichtungsvorrichtung mit zwei HPPMS und zwei konventionellen Magnetrons.,
- Fig. 2: in einer Prinzipskizze die Verschaltung einer Leistungsversorgung der Beschichtungsvorrichtung gemäß Fig. 1,
- Fig. 3: in einer Prinzipskizze einen waagerechten Querschnitt durch eine zweite Ausführungsform einer Beschichtungsvorrichtung mit vier HPPMS-Magnetrons,
- Fig. 4: in einer Prinzipskizze die Verschaltung einer Leistungsversorgung der Beschichtungsvorrichtung gemäß Fig. 3,
- Fig. 5: in einer Prinzipskizze einen waagerechten Querschnitt durch eine dritte Ausführungsform einer Beschichtungsvorrichtung mit zwei HPPMS und zwei konventionellen Magnetrons, die im Dual-Magnetron-Betrieb arbeiten.
- Fig. 6: in einer Prinzipskizze einen waagerechten Querschnitt durch eine vierte Ausführungsform einer Beschichtungsvorrichtung mit zwei HPPMS Magnetrons und zwei konventionellen Magnetrons, wobei alle Magnetrons gegen eine gemeinsame Anode geschaltet sind,
- Fig. 7: in einer Prinzipskizze einen waagerechten Querschnitt durch eine fünfte Ausführungsform einer Beschichtungsvorrichtung mit vier HPPMS Magnetrons die gegen eine gemeinsame Anode geschaltet sind,
- Fig. 8: in einer Prinzipskizze einen waagerechten Querschnitt durch eine sechste Ausführungsform einer Beschichtungsvorrichtung mit Beschaltung, mittels der zwei HPPMS-Magnetrone bipolar gegeneinander gepulst werden,
- Fig. 9: ein Schaltbild eines Schaltelements zur Ansteuerung eines HPPMS Magnetrons, und
- Fig. 10: in einer Prinzipskizze einen senkrechten Querschnitt durch eine Kammerwandung und daran angebrachte HPPMS-Leistungsversorgung.

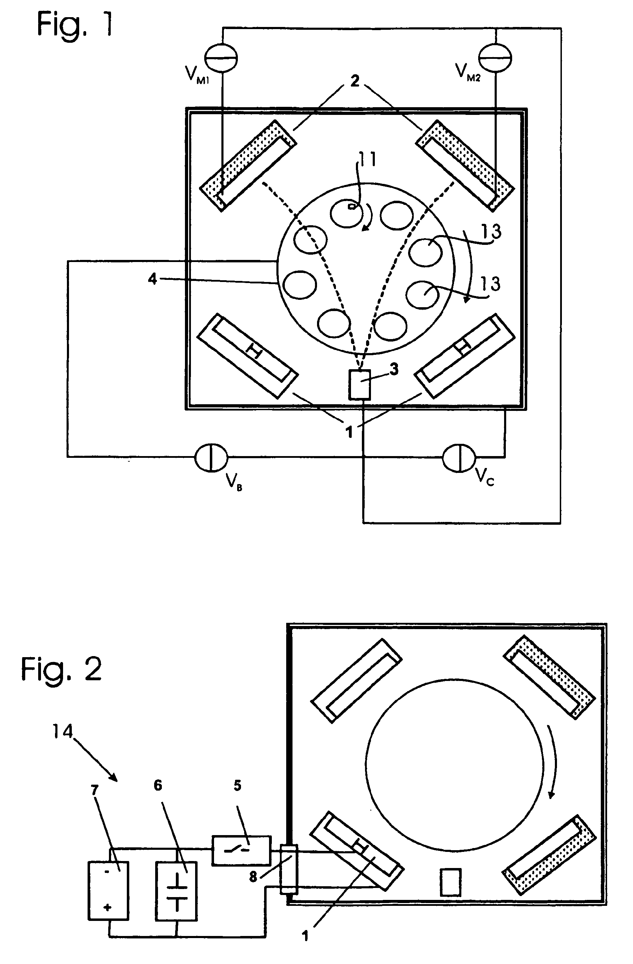

In den Figuren 1-8 ist jeweils eine Beschichtungskammer einer PVD-Sputteranlage dargestellt mit vier Magnetrons und einem drehbaren Substrattisch 4. Die Magnetrons umfassen einen schraffiert dargestellten hinteren Bereich mit Abschirmungen, Kühlvorrichtungen und Magnetsystemen und - nicht schraffiert dargestellt - jeweils ein Target aus dem zu sputternden Material. In den gezeigten Beispielen sind die Targets jeweils als rechteckige Platte ausgebildet, deren Vorderseite dem Substrattisch 4 zugewandt ist.

In den gezeigten Ausführungsformen ist jeweils mindestens eines der Magnetrons als HPPMS-Magnetron ausgebildet und in den Figuren durch die Bezeichnung "H" auf dem Target gekennzeichnet. Hierbei bezieht sich die Bezeichnung als "HPPMS-Magnetron" in erster Linie auf die Beschaltung, d.h. HPPMS-Magnetrons sind an eine HPPMS-Leistungsversorgung angeschlossen, während konventionelle UBM-Magnetrons an eine herkömmliche DC-Leistungsversorgung angeschlossen sind, oder alternativ an eine herkömmliche Puls-Leistungsversorgung mit Spannungspulsen konventioneller Energie. Die Magnetrons selbst sind in den gezeigten Beispielen von ihrem Aufbau her, d.h. Form und Größe der Targets, Magnetsystem, Kühlung etc., identisch. Alternativ wäre es auch möglich, die Magnetron-Vorrichtungen je nach Verwendung als HPPMS- oder konventionelles UBM-Magnetron anzupassen, bspw. in der Stärke oder Form des Magnetfeldes, der Dimensionierung der Kühlung etc..

Die Targets der HPPMS-Magnetrons werden jeweils mit einer separaten HPPMS-Leistungsversorgung betrieben. Als Anode fungieren, wie für die einzelnen Ausführungsformen jeweils angegeben, die Abschirmung des Targets und/oder die Kammerwand, die auf gleichem Potential liegen, oder eine weit entfernte Anode. Die Targets der HPPMS-Magnetrons produzieren im Sputterbetrieb Metallionen, die für die Vorbehandlung und Beschichtung der durch den Substrattisch vorbeigeführten Substrate zur Verfügung stehen. Die weit entfernte Anode wird beim Beschichten gegenüber der Kammerwand durch eine Leistungsversorgung bevorzugt auf einem positiven Potential V_{c} gehalten.

In einem ersten Ausführungsbeispiel (Fig. 1) befinden sich in einer ca. 0,7 m3 großen, metallischen Beschichtungskammer in der Nähe der Kammerwände zwei HPPMS-Magnetrons 1 und zwei konventionellen UBM Magnetrons 2. Dazwischen befindet sich ein drehender Substrattisch 4. Der Substrattisch 4 weist Drehteller 13 auf, auf denen an Gestellen Substrate 11 befestigt und elektrisch leitend verbunden sind. Bei den Substraten handelt es sich um zu beschichtende Körper, deren Form dem jeweiligen Anwendungszweck entspricht, bspw. um Zerspanungswerkzeuge. Die Substrate werden auf den Drehtellern in einer planetären Drehung in wechselnden Abständen an der Magnetrons vorbeigeführt. An den Substrattisch 4, der mit den Substraten leitfähig verbunden ist, wird eine Substratbiasspannung V_{B} gegenüber der Anode 3 angelegt.

Die konventionellen Magnetrons 2 werden beim Beschichten gegen eine Anode 3 betrieben, die sich auf der anderen Seite des Substrattisches 4 befindet. Hierfür erzeugen jeweils einzelne den Magnetrons 2 zugeordnete Leistungsversorgungen Spannungen V_{M1} und V_{M2}, mit denen die Magnetrons 2 als Kathoden auf ein negatives elektrischen Potential gegenüber der Anode 3 gelegt werden. Durch den großen Abstand zwischen den Magnetrons 2 und der Anode 3 legen die an den Kathoden 2 und im Raum erzeugten Elektronen einen langen Weg quer durch die Kammer zurück und erzeugen weitere Ionisationen. An den Substraten 11 steht so im gesamten Beschichtungsvolumen eine hohe Gasionendichte zur Verfügung.

Die Targets der beiden HPPMS-Magnetrons 1 liefern gleichzeitig vorwiegend Metallionen. Sie werden in diesem Beispiel beim Vorbehandeln und Beschichten gegen geerdete Abschirmungen der Magnetrone betrieben, die in diesem Fall als Anode dienen. Durch den aufgrund des Betriebs der HPPMS-Magnetrons 1 gegenüber dem reinen Betrieb allein konventioneller Magnetrons erhöhten Metallionenanteil ergibt sich eine wesentlich verbesserte Schichtqualität und Haftung.

In Fig. 2 ist ein symbolisches Schaltbild einer HPPMS-Leistungsversorgung 14 der Beschichtungsvorrichtung gezeigt, wobei die HPPMS-Leistungsversorgung 14 lediglich exemplarisch für das HPPMS-Magnetron 1 links unten dargestellt ist und dem anderen HPPMS-Magnetron eine weitere, identische HPPMS-Leistungsversorgung (nicht dargestellt) zugeordnet ist. Die HPPMS-Leistungsversorgung 14 umfasst ein Schaltelement 5, ein Kapazitätselement 6 und eine Gleichspannungs-Leistungsversorgung 7.

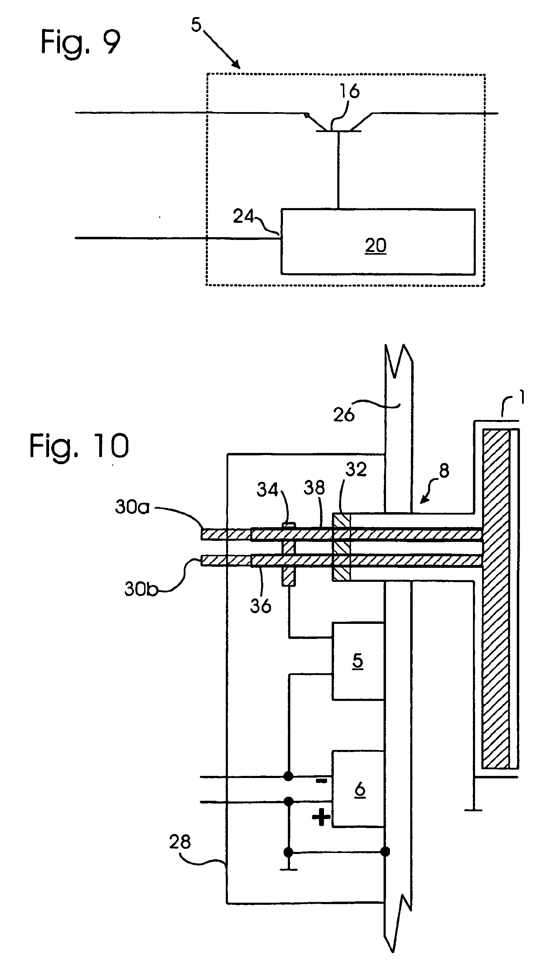

Fig. 9 zeigt ein Schaltbild des Schaltelements 5. Dieses umfasst einen Leistungstransistor 16, der als IGBT ausgeführt ist und in Reihe zwischen dem Kapazitätselement 6 und dem HPPMS-Magnetron 1 angeordnet ist. Der IGBT 16 wird durch eine Steuereinheit 20 angesteuert. Die Steuereinheit 20 verfügt weiter über eine Ansteuerungs-Schnittstelle 24, über der Zustand des Schaltelements vorgegeben wird. Ein externer Steuerungsrechner, der die Dauer und das Timing der Pulse vorgibt, steuert die Steuereinheit 20 entsprechend an.

Das Kapazitätselement 6 ist als Kondensatorbank, d.h. als Parallelschaltung von einzelnen Kondensatoren vorgesehen. In einem bevorzugten Beispiel werden einzelne Kondensatoren jeweils mit einer Spannungsfestigkeit von 2000 Volt verwendet. In der bevorzugten Ausführung werden so viele dieser einzelnen Kondensatoren parallel geschaltet wie benötigt wird, um eine geeignete Gesamtkapazität der Kondensatorbank 6 von bspw. 30 µF oder 50µF zu erreichen.

Wie in Fig. 2 zunächst symbolisch dargestellt, befinden sich das Schaltelement 5 und die Kondensatorbank 6 in unmittelbarer Nähe der Kathoden an einer zugehörigen Elektrovakuumdurchführung 8 auf der Außenseite der Kammerwand. Die Kühlung der Schaltelemente kann durch die Kühlkreisläufe der Kammerwand erfolgen, alternativ ist auch eine Luftkühlung möglich.

Die Gleichspannungs-Leistungsversorgung 7, die die Kondensatoren der Kondensatorbank 6 in den Pulspausen auflädt, hat im Vergleich zu den Pulsleistungen nur geringe Leistungsanforderungen und befindet sich in einem entfernteren Schaltschrank.

In Fig. 10 ist in einer Prinzipskizze die Anordnung der Kondensatorbank 6 und des Schaltelements 5 an der Kammerwandung 26 dargestellt. Diese sind in einem Gehäuse 28 angeordnet, das direkt an der Kammerwandung 26 angebracht ist.

Für das in der Kammer angeordnete HPPMS-Magnetron 1 ist eine Wasserkühlung vorgesehen mit einem Kühlmittelzufluss 30a und einem Kühlmittelrückfluss 30b. Die Kühlmittelversorgung wird zunächst durch Schläuche zum Gehäuse 28 geführt. Die weitere Zu- und Abführung des Kühlmittels zum HPPMS-Magnetron 1 erfolgt durch Kupferrohre 36, 38, die durch eine Vakuumisolierung 32 der Kammerwandung 26 geführt sind.

Die Kupferrohre 36, 38 werden auch als elektrische Leitung genutzt, um die HPPMS-Strompulse vom Schaltelement 5 zum Magnetron 1 zu leiten. Hierfür ist der elektrische Ausgang des Schaltelements 5 über eine Muffe 34 mit beiden Rohren 36, 38 elektrisch verbunden. Das Isolierelement 32 sorgt für eine elektrische Isolierung gegenüber der Kammerwandung 26.

So ergibt sich einerseits ein sehr einfacher Aufbau an der Durchführung 8. Andererseits können die Rohre 36, 38 als Leiter mit relativ großem Querschnitt gut zur Leitung der sehr hohen Ströme verwendet werden. Dadurch, dass die Rohre 36, 38 selbst das Kühlmittel leiten, ergibt sich ohne zusätzlichen Aufwand eine Kühlung der elektrischen Leitungen.

Die Kondensatorbank 6 und das Schaltelement 5 sind somit direkt nebeneinander angeordnet, d.h. bspw. weniger als 80 cm voneinander entfernt, bevorzugt sogar weniger als 20 cm voneinander entfernt, um die Leitungswege, durch die die Strompulse geleitet werden, möglichst kurz zu halten. Die Kondensatorbank 6 und das Schaltelement 5 sind auch nahe des HPPMS-Magnetrons 1 angebracht, das auf der anderen Seite der Kammerwand 26 angeordnet ist, so dass auch hier die Stromwege kurz gehalten sind, bevorzugt ab dem Schaltelement 5 bis zum HPPMS-Magnetron 1 weniger als 50cm, besonders bevorzugt weniger als 30cm.

Weiter ist die Anordnung so beschaffen, dass lediglich ein Minimum an Leitungslänge, durch die der Strom eines HPPMS-Pulses geleitet wird, ausserhalb der Vakkumkammer angeordnet ist. Die metallische Vakuumkammer wirkt als faradayscher Käfig, so dass elektromagnetischen Störungen außerhalb der Anlage minimiert werden und eine hohe Betriebssicherheit erreicht wird.

In einer beispielhaften Bestückung der Beschichtungsvorrichtung gemäß der ersten Ausführungsform bestehen alle Targets, bis auf ein erstes HPPMS-Target, das nur aus Titan besteht, aus Titanplatten, in die Aluminiumstopfen eingelassen sind (Ti-Al Target).

Nachfolgend wird beispielhaft der Betrieb der Beschichtungsvorrichtung gemäß der ersten Ausführungsform zum Vorbehandeln und Beschichten von auf dem Substrattisch 4 chargierten Körpern (Substraten) 11 beschrieben, bspw. von Zerspanungswerkzeugen.

Die Substrate werden zunächst auf ca. 500°C aufgeheizt. In einem ersten Ätzschritt wird Argongas in die Kammer eingelassen und die beiden konventionellen Magnetrons 2 werden als Anode gemeinsam gegen die jeweils ca. 45 cm entfernte Elektrode 3 betrieben, die beim Ätzen als Kathode fungiert. Dabei werden die Substrate auf ein negatives Potential gelegt. Die so in Substratnähe erzeugte hohe Gasionendichte führt im ersten Ätzschritt zu einer ersten Reinigung und Aktivierung der Substratoberfläche.

In einem zweiten Schritt wird bei sonst gleichem Betrieb wie im ersten Ätzschritt zusätzlich das erste HPPMS-Magnetron 1, dessen Target nur aus Titan besteht, bei einem niedrigen Argondruck betrieben. Die Substrate werden durch geeignete Einstellung der Spannungen V_{B} und V_{C} auf ein neues höheres negatives Potential von -1100 V gegenüber der Kammerwand gelegt. Die Metallionen reinigen und ätzen die Substratoberfläche. Ein kleiner Teil der Ionen wird oberflächennah implantiert. Wegen des nach wie vor vorhandenen Argondrucks findet gleichzeitig ebenfalls ein Beschuss mit Argonionen statt.

Innerhalb eines Übergangszeitraumes von mehreren Minuten, in einem Beispiel von 5 Minuten, wird der Substratbias kontinuierlich von -1100 V auf -100 V reduziert. Dabei bildet sich ein dünnes Interface aus Ti.

Anschließend wird wenige Minuten lang Stickstoff eingelassen. Es bildet sich eine dünne Hartstoffschicht aus TiN. Anschließend wird der Argon- und Reaktivgasfluss erhöht und das zweite HPPMS-Magnetron (mit Ti-Al Target) zugeschaltet. Ferner werden die konventionellen Magnetrons 2 nun im Gleichstrom-Betrieb als Kathode gegen die Elektrode 3, die jetzt als Anode fungiert, betrieben.

Die drei zusätzlichen Magnetrons setzen Al- und Ti-Atome sowie Al- und Ti- Ionen frei. Durch die Leistung an den einzelnen Magnetrons kann die Stöchiometrie der Hartstoffschicht eingestellt werden.

Die vor den Magnetrons 2 produzierten Elektronen bewegen sich im elektrischen Feld auf die Anode 3 zu und erzeugen auf diesem Weg in Substratnähe weitere Ladungsträger. Das elektrische Feld ist in Fig. 1 und in den folgenden Abbildungen symbolisch durch eine gestrichelte Linie angedeutet. Diese Linie entspricht in etwa der elektrischen Feldlinie, die die Mitte der beiden Elektroden eines Elektrodenpaares trifft. Durch die weiteren Elektroden in der Kammer kann es zur Verzerrung der Feldlinien kommen. Besonders durch die sich drehen den Substrate kann es zeitweise zu erheblichen Abweichungen kommen. Im zeitlichen Mittel aber hat die Feldlinie in etwa den gezeigten Verlauf. Die Sichtlinien zwischen den aktiven Elektrodenflächen weichen bei größeren Abständen nur wenig von den Feldlinien ab. Die sich vorbeidrehenden Substrate schneiden diese Sichtlinien zumindest teilweise und zeitweise. Die so erzeugten Gasionen stehen so in hoher Konzentration an den Substraten zur Verfügung. Die Ionen werden während der Beschichtung durch die Substratbiasspannung V_{B} in Richtung auf die Substrate beschleunigt. Die Ionen des Sputtergases verdichten dabei die Schichten, während die Ionen des Reaktivgases mit den gesputterten Metallionen und -atomen zum gewünschten Beschichtungsmaterial TiAlN reagieren könnten. Die Metallatome stammen vorwiegend von den konventionellen UBM Magnetrons, die Metallionen hingegen überwiegend von den HPPMS-Magnetrons. Durch diese Kombination entstehen besonders harte und haftfeste Schichten mit guter Schichtrate.

Werden anderseits Schichten bei sonst gleichem Versuchsaufbau nur mit konventionellen UBM-Magnetrons hergestellt, ergeben sich Schichten mit im Vergleich geringerer Härte und Haftfestigkeit, sowie mit einer erhöhten Rauheit.

Bei der Bearbeitung von auf 1400 MPa gehärteten Flachstahl aus X38CrMoV51 konnte auf 10 mm Radiusfräsern so eine um 21 % höhere Standzeit erzielt werden.

In einem Vergleichsbeispiel wurden zwar neben konventionellen UBM-Magnetrons auch HPPMS-Magnetrons verwendet, aber alle Magnetrons jeweils gegenüber der geerdeten Abschirmung betrieben. In dem Vergleichsbeispiel kam es zwar teilweise ebenfalls zu einer Verbesserung der Haftfestigkeit und Härte gegenüber einer Beschichtung alleine mit konventionellen UBM-Magnetrons. Die Schichteigenschaften waren jedoch nicht homogen auf dem gesamten Substrat festzustellen.

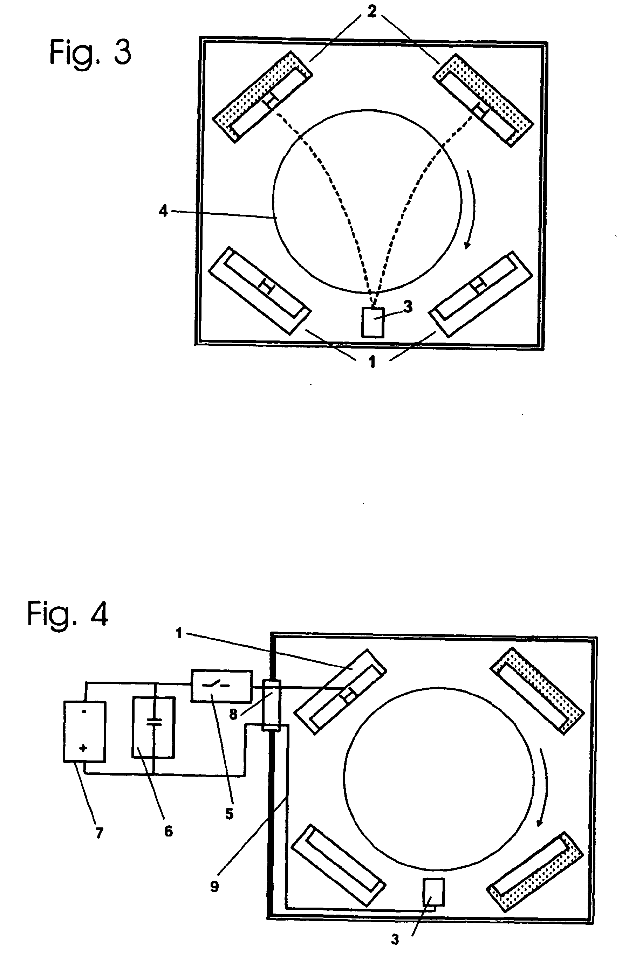

In einem zweiten Ausführungsbeispiel gemäß Fig. 3, das im Übrigen mit dem ersten Ausführungsbeispiel übereinstimmt, sind vier HPPMS-Magnetrons vorgesehen. Zwei der HPPMS-Magnetrons werden gegen eine weit entfernte Anode betrieben, so dass auch hier die Elektronen einen weiten Weg zurücklegen und ebenfalls für eine hohe Gasionisation im gesamten Beschichtungsvolumen sorgen.

Fig. 4 zeigt für die zweite Ausführungsform beispielhaft und in Bezug auf Fig. 3 die Verschaltung eines HPPMS-Magnetrons und der zugehörigen Gegenelektrode. Die elektrische Zuleitung 9 zur Anode 3 auf der anderen Seite des Substrattisches verläuft im Inneren der Vakuumkammer entlang der Kammerwände hinter Abschirmblechen (nicht dargestellt). Durch diese Anordnung werden elektromagnetischen Störungen außerhalb der Beschichtungsvorrichtung minimiert und es wird eine hohe Betriebssicherheit erreicht.

Beim Beschichten von Substraten mit der Anordnung gemäß dem zweiten Ausführungsbeispiel wurden bei sonst gleichem Aufbau und Prozessverlauf Schichten mit noch höherer Härte, aber mit hohen Druckspannungen erzeugt. Solche Schichten sind besonders zur Hartzerspanung geeignet und werden bevorzugt nur mit geringen Schichtdicken aufgebracht. Im Vergleich zum Anwendungsbeispiel der ersten Ausführungsform ergab sich eine um weitere 16% erhöhte Standzeit, also gegenüber konventioneller Beschichtung eine Verbesserung um insgesamt 37%.

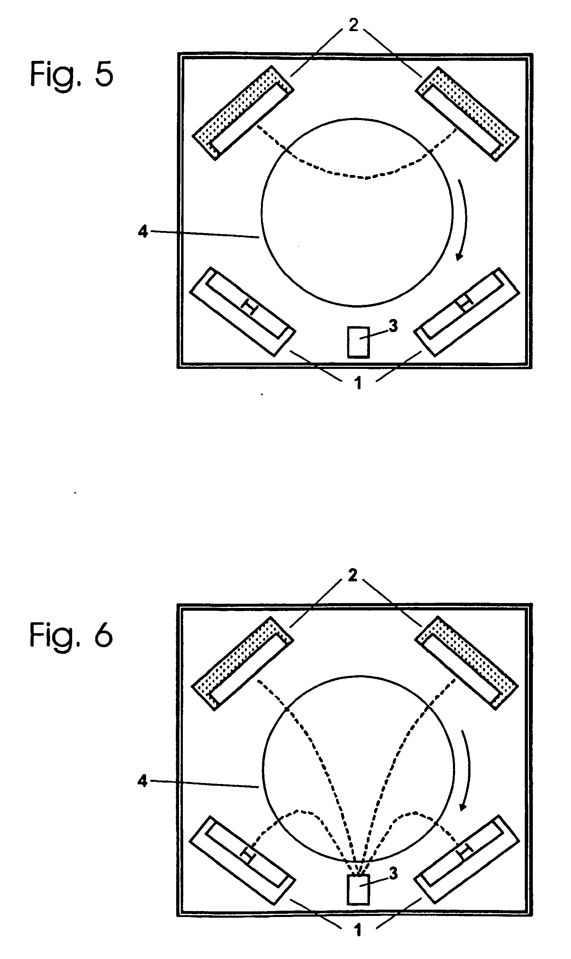

In Fig. 5 ist eine dritte Ausführungsform einer Beschichtungsvorrichtung dargestellt, die bevorzugt zur Vorbehandlung von Substraten und/oder zur Beschichtung von Substraten mit nichtleitenden Schichten, bspw. Oxidschichten wie Aluminiumoxid, eingesetzt werden kann. Die Beschichtungsvorrichtung, die bis auf die gezeigten und hier diskutierten Details zur Verschaltung mit den oben genannten Ausführungsformen übereinstimmt, umfasst zwei HPPMS-Magnetrons und zwei konventionelle Magnetrons. Eines der HPPMS-Magnetronsist mit einem Target aus Chrom bestückt und wird nur bei der Vorbehandlung und beim Aufbringen von Zwischenschichten verwendet; die Targets der anderen Magnetrons bestehen aus Aluminium. Dabei werden die zwei konventionelle UBM-Magnetrons beim Beschichten im Dual-Magnetron-Betrieb betrieben.

Nachfolgend wird beispielhaft der Betrieb der Beschichtungsvorrichtung gemäß der dritten Ausführungsform zum Erzeugen von Oxidschichten beschrieben:

Zunächst wird eine Ätzbehandlung analog zum beispielhaften Betrieb der ersten Ausführungsform durchgeführt, wobei allerdings anstelle eines HPPMS-Titantargets ein HPPMS-Chromtarget verwendet wird. Wie im ersten Beispiel wird eine Hartstoffzwischenschicht hergestellt, indem zunächst eine Metallschicht des Targetmaterials abgeschieden wird und dann ein Reaktivgas eingelassen wird. Im beispielhaften Betrieb der dritten Ausführungsform wird eine CrN-Hartstoffzwischenschicht erzeugt, indem zunächst eine Cr-Schicht abgeschieden und dann Stickstoff als Reaktivgas eingelassen wird.

Im weiteren Beschichtungsbetrieb wird das Reaktivgas Stickstoff durch Sauerstoff ersetzt, so dass sich zunächst eine sehr dünne Cr-N-O Übergangsschicht und dann eine Cr₂O₃ Hartstoffzwischenschicht bildet.

Während anschließend die Leistung des Cr-Magnetrons zurückgefahren wird, wird dem Al-HPPMS-Magnetron und den beiden konventionellen Al-Magnetrons ansteigende elektrische Leistung zugeführt, um die eigentliche Al₂O₃-Hartstoffschicht zu bilden.

Das Al-HPPMS-Magnetron wird hierbei gegen die Kammerwand betrieben. Die beiden konventionellen Magnetrons werden bei einem Abstand von 45 cm und bei 50 kHZ im Dual-Magnetron Betrieb betrieben.

Aufgrund der Verwendung eines HPPMS-Magnetrons gemeinsam mit den beiden konventionellen mit Al-Target bestückten Magnetrons wird eine hohe Schichtqualität erzielt. Ferner hat sich gezeigt, dass die Prozessstabilität und Schichthomogenität sehr gut sind und es selten zu Aufladungen und Überschlägen (Arcs) kommt.

Fig. 6 zeigt eine Darstellung einer vierten Ausführungsform einer Beschichtungsvorrichtung. In der vierten Ausführungsform, die wiederum sonst mit den vorerwähnten Ausführungen übereinstimmt, enthält die Beschichtungsvorrichtung zwei HPPMS-Magnetrons und zwei konventionelle Magnetrons, wobei alle Magnetrons gegen eine gemeinsame Anode geschaltet sind, um eine hohe Dichte an Metall- und Gasionen im gesamten Beschichtungsraum zu erzielen.

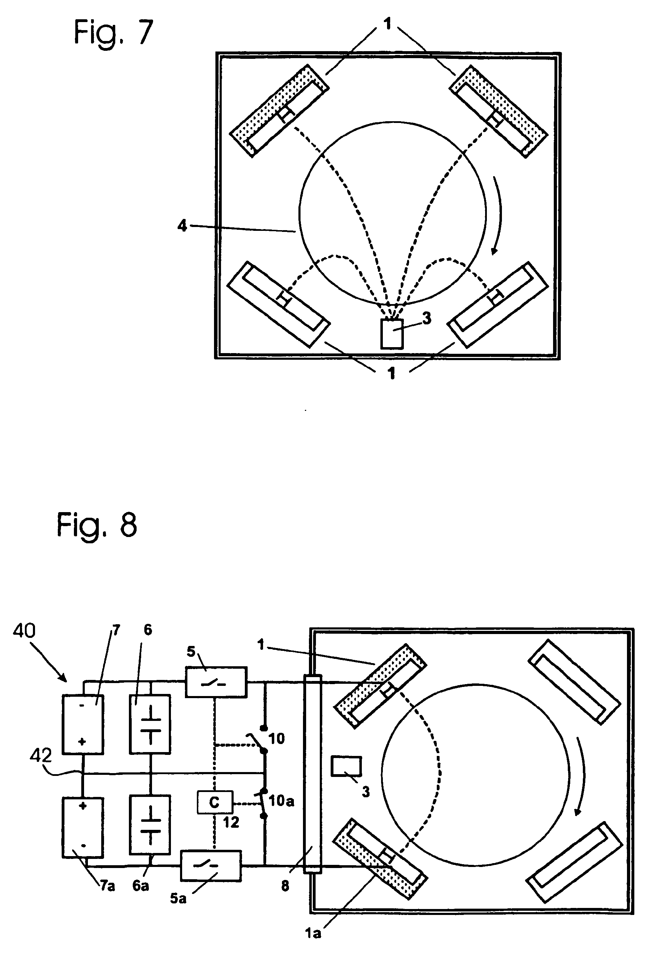

Fig. 7 zeigt eine Darstellung einer fünften Ausführungsform einer Beschichtungsvorrichtung. In der fünften Ausführungsform, die wiederum sonst mit den vorerwähnten Ausführungen übereinstimmt, enthält die Beschichtungsvorrichtung vier HPPMS-Magnetrons, die alle gegen eine gemeinsame Anode geschaltet sind, um eine hohe Dichte an Metallionen im gesamten Beschichtungsvolumen zu erzeugen.

Im Betrieb der Beschichtungsvorrichtung gemäß der fünften Ausführungsform können besonders haftfeste Schichten durch ein vorgeschaltetes Ätzen mit Metallionen erreicht werden. Die Schichtqualität ist ebenfalls sehr gut. Ferner wird auch in konkaven Geometrien eine hohe Schickdickenhomogenität erzielt. Allerdings ist im Vergleich zu den anderen Beispielen die Schichtrate etwas vermindert. Die elektrische Versorgung der HPPMS-Magnetrone ist wie in den vorherigen Beispielen ausgebildet.

In einer weiteren, in Fig. 8 gezeigten sechsten Ausführungsform einer Beschichtungsvorrichtung, die sonst mit den vorerwähnten Ausführungen übereinstimmt, werden zwei HPPMS-Magnetrons bipolar gegeneinander gepulst.

In der sechsten Ausführungsform sind die beiden HPPMS-Magnetrons an eine gemeinsame HPPMS-Leistungsversorgung 40 angeschlossen. Die Leistungsversorgung 40 umfasst zwei DC-Leistungsversorgungen 7, 7a, die symmetrisch an einen Mittelabgriff 42 angeschlossen sind. Parallel zu den DC-Leistungsversorgungen 7, 7a sind Kapazitätselemente 6, 6a angeschlossen, die bevorzugt beide als Kondensatorbank ausgebildet sind, wie im Zusammenhang mit der ersten Ausführungsform erläutert. Der jeweils negative Pol jedes Kapazitätselements 6, 6a ist über ein in Reihe geschaltetes Schaltelement 5, 5a mit dem Target des jeweiligen Magnetron 1, 1a elektrisch verbunden.

Mittels zweier zusätzliche Schalter 10, 10a, die von einer Steuereinheit 12 gesteuert werden, kann jeder der beiden symmetrischen Teile der HPPMS-Leistungsversorgung 40 kurzgeschlossen werden. Die Schalter 10, 10a verbinden im bipolaren Pulsbetrieb der Magnetrons 1, 1a, bei der die Targets jeweils abwechselnd gegeneinander als Anode und Kathode wirken, jeweils das Target, das beim nächsten Puls als Anode wirken soll, mit dem positiven Pol der zugehörigen HPPMS-Leistungsversorgung. Der andere Schalter bleibt offen. So wirkt bei jedem Puls eines der beiden HPPMS-Magnetrons als Anode und das andere als zugeordnete Kathode.

Die Anforderungen an die Schalter 10, 10a sind gering, da sie in den Pulspausen und nicht unter Stromfluss geschaltet werden. Für die Synchronisation der Schaltelemente 5, 5a, 10, 10a sorgt eine Steuereinheit 12. Auch hier sind die Schaltelemente gemeinsam an der Kammerrückwand befestigt und mit elektrischen Leitungen, die durch eine gemeinsame Vakuumdurchführung 8 in die Kammer geleitet werden, an den HPPMS-Magnetrons angeschlossen. Die elektrischen Zuleitungen verlaufen dann soweit möglich im Inneren der Kammer, bevorzugt bezüglich der Gesamtlänge, die die HPPMS-Pulse leitet, weit überwiegend im Inneren der Kammer.

In einer alternativen Ausführung (nicht dargestellt) ist eine Ladevorrichtung vorgesehen, die so geschaltet ist, dass sie in der Pulspause beide Kondensatorbänke 6, 6a lädt.

Mit der Anordnung gemäß dem in Fig. 8 dargestellten Beispiel ergeben sich im Betrieb wenig Aufladungen und die Schichten werden glatt. Die beiden anderen Magnetrons können ebenfalls HPPMS-Magnetrons sein und auf die gleiche Weise betrieben werden. Möglich ist auch der Betrieb gegen Erde oder eine gemeinsame Gegenelektrode 3. Alternativ können die beiden anderen Magnetrons auch konventionelle Magnetrons sein. Sie können bspw. im Dual-Magnetron-Betrieb oder ebenfalls gegen Erde und eine gemeinsame Elektrode betrieben werden.

## Patentansprüche

1. Vorrichtung zum Vorbehandeln und Beschichten von Körpern durch Magnetronzerstäuben, mit
- einer Vakuumkammer mit metallischer Kammerwandung (26) und mit darin angeordneten Magnetrons (1, 2) mit Sputter-Targets,
- wobei mindestens eines der Magnetrons als HPPMS-Magnetron (1) zum Betrieb nach dem hochleistungsgepulsten Magnetronzerstäuben vorgesehen ist,
- wobei dem HPPMS-Magnetron (1) elektrische Pulse zugeführt werden, indem ein Kapazitätselement (6) durch ein Schaltelement (5) mit dem Sputter-Target des HPPMS-Magnetrons (1) verbunden wird,
**dadurch gekennzeichnet, dass**
- das Schaltelement (5) an der Kammerwandung (26) angeordnet ist.

2. Vorrichtung nach Anspruch 1, bei der
- das Kapazitätselement (6) als Kondensatorbank aus parallel geschalteten Kondensatoren ausgebildet ist,
- und das Schaltelement (5) und das Kapazitätselement (6) an der Kammerwandung (26) angeordnet sind.

3. Vorrichtung nach einem der vorangehenden Ansprüche, bei der
- an der Kammerwandung (26) eine Vakuumdurchführung (8) zur elektrischen Versorgung des HPPMS-Magnetrons vorgesehen ist,
- wobei das Kapazitätselement (6), das Schaltelement (5) und die Vakuumdurchführung (8) eine Einheit bilden.

4. Vorrichtung nach einem der vorangehenden Ansprüche, bei der
- eine Kühleinrichtung für das HPPMS-Magnetron (1) vorgesehen ist, bei der Kühlmittel durch Rohre (36, 38) zum HPPMS-Magnetron (1) geleitet wird,
- wobei die Rohre (36, 38) durch eine Vakuumdurchführung (8) durch die Kammerwandung (26) geführt werden,
- und wobei die Rohre (36, 38) als elektrische Leiter genutzt werden, mit denen Strom von dem Schaltelement (5) zum HPPMS-Magnetron (1) geleitet wird.

5. Vorrichtung nach einem der vorangehenden Ansprüche, bei der
- eine Kühleinrichtung für die Kammerwand und/oder eine Vakuumdurchführung daran vorgesehen ist,
- wobei die Kühleinrichtung auch für die Kühlung des Schaltelementes ausgebildet ist.

6. Vorrichtung nach einem der vorangehenden Ansprüche, bei der
- mindestens ein Elektrodenpaar vorgesehen ist, von dem mindestens eine Elektrode ein HPPMS-Magnetron (1) ist,
- wobei elektrische Zuführungen zu den Elektroden des Elektrodenpaars vorgesehen sind,
- und wobei die elektrischen Zuführungen zu beiden Elektroden durch eine gemeinsame Vakuumdurchführung (8) oder zwei benachbarte Vakuumdurchführungen in die Beschichtungskammer geführt werden und die elektrischen Zuführungen innerhalb der Kammer bis zu den Elektroden verlaufen.

7. Vorrichtung nach einem der vorangehenden Ansprüche, mit
- einem Substrattisch (4) zur Aufnahme von zu beschichtenden Körpern,
- und mit mindestens einem Plasma-erzeugenden Elektrodenpaar mit einer ersten Elektrode (1) und einer zweiten Elektrode (3),
- wobei die erste Elektrode das HPPMS-Magnetron (1) ist, das nach dem hochleistungsgepulsten Magnetronzerstäuben betrieben wird, wobei eine HPPMS-Leistungsversorgung zwischen der ersten und der zweiten Elektrode vorgesehen ist,
- und wobei die erste und die zweite Elektrode so angeordnet sind, dass ein am Substrattisch (4) aufgenommener Körper zwischen den aktiven Flächen des Elektrodenpaares angeordnet ist oder durch den Zwischenraum der aktiven Flächen des Elektrodenpaares bewegt wird.

8. Vorrichtung nach Anspruch 7, bei der
- mindestens ein weiteres Elektrodenpaar in der Vakuumkammer angeordnet ist,
- von dem mindestens eine Elektrode als Magnetron (2) ausgebildet ist, das mit einer Gleichspannungs-Leistungsversorgung oder einer konventionellen Puls-Leistungsversorgung verbunden ist.

9. Vorrichtung nach Anspruch 7 oder 8, bei der
- der Abstand zwischen den aktiven Flächen mindestens eines der Elektrodenpaare mehr als 20 cm, bevorzugt mehr als 40 cm, besonders bevorzugt mehr als 60 cm beträgt.

10. Vorrichtung nach einem der Ansprüche 7-9, bei der
- die zweite Elektrode eine Anode (3) ist
- und wobei eine Bias-Spannungsversorgung (V_{B}) zur Erzeugung einer Biasspannung zwischen der Anode (3) und dem Substrattisch (4) vorgesehen ist.

11. Vorrichtung nach Anspruch 10, bei der
- die dem Plasma ausgesetzte Fläche der Anode (3) beim Beschichten kleiner ist als die dem Plasma ausgesetzte Fläche der ersten Elektrode (1).

12. Vorrichtung nach Anspruch 10 oder 11, bei der
- eine elektrische Leistungsversorgung (Vc) zwischen der Anode und der Kammerwandung vorgesehen ist, um die Anode beim Beschichten auf einem gegenüber der Kammerwandung positiven Potential zu halten.

13. Vorrichtung nach einem der Ansprüche 10 bis 12, bei der
- beim Beschichten mindestens zwei Magnetrons gegen eine gemeinsame Anode (3) geschaltet werden.

14. Vorrichtung nach Anspruch 7, bei der
- die zweite Elektrode ein HPPMS-Magnetron (1a) ist,
- und zwischen der ersten und zweiten Elektrode eine HPPMS-Leistungsversorgung (40) vorgesehen ist, mit der die Elektroden (1, 1a) bipolar gegeneinander gepulst betrieben werden können.

15. Verfahren zum Vorbehandeln und Beschichten eines Körpers mittels Magnetronzerstäubens, bei dem
- der Körper in einer Vakuumkammer mit metallischer Kammerwandung (26) und mit darin angeordneten Magnetrons mit Sputter-Targets angeordnet ist,
- in der Vakuumkammer ein Plasma erzeugt wird, wobei mindestens eines der Sputter-Targets zerstäubt wird,
- und wobei mindestens eines der Magnetrons als HPPMS-Magnetron (1) nach dem hochleistungsgepulsten Magnetronzerstäuben betrieben wird,
- wobei dem HPPMS-Magnetron (1) elektrische Pulse zugeführt werden, indem ein Kapazitätselement (6) durch ein Schaltelement (5) mit dem Sputter-Target des HPPMS-Magnetrons (1) verbunden wird,
**dadurch gekennzeichnet, dass**
- das Schaltelement (5) an der Kammerwandung (26) angeordnet ist.

## Claims

1. A device for pre-treating and coating bodies by means of magnetron sputtering comprising
- a vacuum chamber having a metallic chamber wall (26) and magnetrons (1, 2) arranged therein with sputter targets,
- wherein at least one of the magnetrons is provided as an HPPMS magnetron (1) to be operated according to the high power pulsed magnetron sputtering process,
- wherein the HPPMS magnetron (1) is supplied with electrical pulses by connecting a capacitive element (6) to the sputter target of the HPPMS magnetron (1) by means of a switch element (5), **characterized in that**
- the switch element (5) is arranged on the chamber wall (26).

2. The device according to claim 1, wherein
- the capacitive element (6) is designed as a capacitor bank consisting of parallel-connected capacitors,
- and the switch element (5) and capacitive element (6) are arranged on the chamber wall (26).

3. The device according to one of the prior claims, wherein
- a vacuum feedthrough (8) is provided in the chamber wall (26) to electrically supply the HPPMS magnetron,
- wherein the capacitive element (6), the switch element (5) and the vacuum feedthrough (8) form a unit.

4. The device according to one of the preceding claims, wherein
- a cooling device is provided for the HPPMS magnetron (1), wherein the coolant is guided through pipes (36, 38) to the HPPMS magnetron (1),
- wherein the pipes (36, 38) are guided through a vacuum feedthrough (8) through the chamber wall (26),
- and wherein the pipes (36, 38) are used as electrical conductors by means of which current is conducted from the switch element (5) to the HPPMS magnetron (1).

5. The device according to one of the preceding claims, wherein
- a cooling device is provided for the chamber wall and/or a vacuum feedthrough on the same,
- wherein the cooling device is also designed for cooling the switch element.

6. The device according to one of the preceding claims, wherein
- at least one electrode pair is provided, of which at least one electrode is an HPPMS magnetron (1),
- wherein electrical leads are provided to the electrodes of the electrode pair,
- and wherein the electrical leads run through a common vacuum feedthrough (8) or two neighboring vacuum feedthroughs into the coating chamber, and the electrical leads run within the chamber up to the electrodes.

7. The device according to one of the preceding claims, comprising
- a substrate table (4) to receive bodies to be coated
- and at least one plasma-generating electrode pair with a first electrode (1) and a second electrode (3),
- wherein the first electrode is the HPPMS magnetron (1) that is operated according to the high power pulsed magnetron sputtering mode, wherein an HPPMS power supply is provided between the first and second electrode,
- and wherein the first and second electrode are arranged such that a body mounted on the substrate table (4) is arranged between the active surfaces of the electrode pair or is moved through the space between the active surfaces of the electrode pair.

8. The device according to claim 7 wherein
- at least one other electrode pair is arranged in the vacuum chamber,
- of which at least one electrode is designed as a magnetron (2) that is connected to a DC power source supply or a conventional pulse power supply.

9. The device according to claim 7 or 8, wherein
- the distance between the active surfaces of at least one of the electrode pairs is more than 20 cm, preferably more than 40 cm and particularly preferably more than 60 cm.

10. The device according to one of claims 7-9, wherein
- the second electrode is an anode (3),
- and wherein a bias voltage supply (V_{B}) is provided to generate a bias voltage between the anode (3) and substrate table (4).

11. The device according to claim 10, wherein
- the surface of the anode (3) exposed to the plasma is smaller during coating than the surface of the first electrode (1) exposed to the plasma.

12. The device according to claim 10 or 11, wherein
- an electrical power supply (V_{C}) is provided between the anode and chamber wall to keep the anode at a potential that is positive in comparison to the chamber wall during coating.

13. The device according to one of claims 10 to 12, wherein
- at least two magnetrons are connected against a common anode (3) during coating.

14. The device according to claim 7, wherein
- the second electrode is an HPPMS magnetron (1a)
- and an HPPMS power supply (40) is provided between the first and second electrode by means of which the electrodes (1, 1a) can be operated pulsed against each other in a bipolar fashion.

15. A method for pretreating and coating a body by means of magnetron sputtering, wherein
- the body is arranged in a vacuum chamber with a metallic chamber wall (26) and with magnetrons with sputter targets arranged therein,
- a plasma is generated in the vacuum chamber, wherein at least one of the sputter targets is sputtered,
- and wherein at least one of the magnetrons is operated as an HPPMS magnetron (1) according to the high power pulsed magnetron sputtering process,
- wherein electrical pulses are supplied to the HPPMS magnetron (1) by connecting a capacitive element (6) to the sputter target of the HPPMS magnetron (1) by means of a switch element (5) **characterized in that**
- the switch element (5) is arranged on the chamber wall (26).

## Revendications

1. Dispositif de prétraitement et de revêtement de corps par pulvérisation à magnétron, comprenant
une chambre à vide avec une paroi de chambre métallique (26) et avec des magnétrons (1, 2) situés dans celle-ci munis de cibles de pulvérisation,
au moins un des magnétrons étant prévu comme magnétron HPPMS (1) pour le fonctionnement selon la pulvérisation à magnétron pulsé à haute puissance,
des impulsions électriques étant délivrées au magnétron HPPMS (1), en reliant un élément de capacité (6) via un élément de commutation (5) à la cible de pulvérisation du magnétron HPPMS (1).
**caractérisé en ce que**
l'élément de commutation (5) est agencé sur la paroi de chambre (26).

2. Dispositif selon la revendication 1, dans lequel
l'élément de capacité (6) se présente sous la forme d'un banc de condensateurs constitué de condensateurs montés en parallèle,
et l'élément de commutation (5) et l'élément de capacité (6) sont agencés sur la paroi de chambre (26).

3. Dispositif selon une des revendications précédentes, dans lequel
une conduite à vide (8) pour l'alimentation électrique du magnétron HPPMS est prévue sur la paroi de chambre (26),
l'élément de capacité (6), l'élément de commutation (5) et la conduite à vide (8) formant une unité.

4. Dispositif selon une des revendications précédentes, dans lequel
un dispositif réfrigérant est prévu pour le magnétron HPPMS (1), dans lequel des agents réfrigérants sont dirigés à travers des conduits (36, 38) vers le magnétron HPPMS (1),
les conduits (36, 38) sont guidés à travers une conduite à vide (8) via la paroi de chambre (26),
et les conduits (36, 38) sont utilisés comme des conducteurs électriques, avec lesquels le courant est dirigé de l'élément de commutation (5) au magnétron HPPMS (1).

5. Dispositif selon une des revendications précédentes, dans lequel
un dispositif réfrigérant pour la paroi de chambre et/ou une conduite à vide est prévu(e),
le dispositif réfrigérant étant également configuré pour le refroidissement de l'élément de commutation.

6. Dispositif selon une des revendications précédentes, dans lequel
au moins une paire d'électrodes est prévue, dont au moins une électrode est un magnétron HPPMS (1),
des alimentations électriques vers les électrodes de la paire d'électrodes sont prévues,
et les alimentations électriques vers les deux électrodes sont guidées à travers une conduite à vide (8) commune ou deux conduites à vide adjacentes dans la chambre de revêtement et les alimentations électriques s'étendent à l'intérieur de la chambre jusqu'aux électrodes.

7. Dispositif selon une des revendications précédentes, comprenant
une table de substrat (4) pour la réception des corps devant recevoir un revêtement,
et au moins une paire d'électrodes produisant du plasma avec une première électrode (1) et une seconde électrode (3),
la première électrode étant le magnétron HPPMS (1) qui fonctionne selon la pulvérisation à magnétron pulsé à haute puissance, une alimentation de puissance HPPMS étant prévue entre les première et seconde électrodes,
les première et seconde électrodes étant agencées de telle sorte qu'un corps positionné sur la table de substrat (4) est agencé entre les surfaces actives de la paire d'électrodes ou est déplacé à travers l'espace intermédiaire des surfaces actives de la paire d'électrodes.

8. Dispositif selon la revendication 7, dans lequel
au moins une autre paire d'électrodes est située dans la chambre à vide,
au moins une des électrodes de la paire est configurée sous forme de magnétron (2) qui est relié à une alimentation de puissance à tension continue ou une alimentation de puissance pulsée conventionnelle.

9. Dispositif selon les revendications 7 ou 8, dans lequel
la distance entre les surfaces actives d'au moins une des paires d'électrodes est supérieure à 20 cm, de façon préférentielle supérieure à 40 cm, de façon particulièrement préférentielle supérieure à 60 cm.

10. Dispositif selon une des revendications 7 à 9, dans lequel
la seconde électrode est une anode (3)
et une alimentation de tension de polarisation (V_{B}) est prévue pour produire une tension de polarisation entre l'anode (3) et la table de substrat (4).

11. Dispositif selon la revendication 10, dans lequel
la surface exposée au plasma de l'anode (3) est plus réduite lors du revêtement que la surface exposée au plasma de la première électrode (1).

12. Dispositif selon la revendication 10 ou 11, dans lequel
une alimentation de puissance électrique (V_{C}) entre l'anode et la paroi de chambre est prévue, pour maintenir l'anode lors du revêtement sur un potentiel positif par rapport à la paroi de chambre.

13. Dispositif selon une des revendications 10 à 12, dans lequel
lors du revêtement au moins deux magnétrons sont commutés contre une anode commune (3).

14. Dispositif selon la revendication 7, dans lequel
la seconde électrode est un magnétron HPPMS (la),
et entre la première et la seconde électrode est prévue une alimentation de puissance HPPMS (40) avec laquelle les électrodes (1, 1a) peuvent fonctionner en mode bipolaire de manière pulsée l'une par rapport à l'autre.

15. Procédé de prétraitement et de revêtement d'un corps au moyen de la pulvérisation à magnétron, dans lequel
le corps est disposé dans une chambre à vide avec une paroi de chambre métallique (26) et avec des magnétrons situés dans celle-ci dotés de cibles de pulvérisation,
un plasma est produit dans la chambre à vide, au moins une des cibles de pulvérisation étant pulvérisée,
et au moins un des magnétrons fonctionnant comme magnétron HPPMS (1) selon la pulvérisation à magnétron pulsé à haute puissance,
des impulsions électriques étant délivrées au magnétron HPPMS (1), en reliant un élément de capacité (6) via un élément de commutation (5) à la cible de pulvérisation du magnétron HPPMS (1),
**caractérisé en ce que**
l'élément de commutation (5) est agencé sur la paroi de chambre (26).
